Europäisches Patentamt

European Patent Office

Office européen des brevets

(19)

(11) Publication number: **0 020 744**
**B1**

(12) **EUROPEAN PATENT SPECIFICATION**

(45) Date of publication of patent specification: **20.07.83**

(51) Int. Cl.³: **H 03 D 3/22, H 03 D 5/00**

(21) Application number: **80900178.7**

(22) Date of filing: **21.12.79**

(86) International application number:
**PCT/US79/01118**

(87) International publication number:
**WO 80/01344 26.06.80 Gazette 80/14**

(54) **AM-FM DETECTOR CIRCUIT.**

(30) Priority: **22.12.78 US 972645**

(43) Date of publication of application:
**07.01.81 Bulletin 81/1**

(45) Publication of the grant of the patent:
**20.07.83 Bulletin 83/29**

(84) Designated Contracting States:
**DE GB**

(56) References cited:
**GB - A - 1 503 171**
**GB - A - 1 503 172**
**GB - A - 1 503 173**
**GB - A - 1 511 041**
**GB - A - 1 511 042**
**GB - A - 1 511 043**
**US - A - 3 936 750**
**US - A - 3 999 138**
**US - A - 4 050 022**
**Service Information, for Model 7-2810 F**
**FM/AM Portable Radio, Issued June 1976 by**
**General Electric Company**

(73) Proprietor: **GENERAL ELECTRIC COMPANY**
**1 River Road**
**Schenectady New York 12305 (US)**

(72) Inventor: **MC FADYEN, Robert John**
**4892 S.Salina Street**
**Syracuse, NY 13205 (US)**

(74) Representative: **Hughes, Brian P. et al,**
**Graham Watt & Co. Riverhead**
**Sevenoaks, Kent TN13 2BN (GB)**

Courier Press, Leamington Spa, England.

## AM-FM Detector circuit

This invention relates to an AM-FM detector circuit, i.e. a detector circuit which is capable of detecting either the AM-IF (amplitude-modulation intermediate frequency) signals or the FM-IF (frequency-modulation intermediate frequency) signals developed by the IF amplifier of a superheterodyne broadcast radio receiver.

|  | United States Patent Specification No. | Corresponding British Patent Specification No. |
|---|---|---|
| AA. | 3,936,750 McFadyen and Peil | 1,511,041 1,511,042 1,511,043 |
| BB. | 3,999,138 McFadyen and Peil | 1,503,171 1,503,172 1,503,173 |
| CC. | 4,050,022 McFadyen and Peil | |

DD. Publication: Service Information for Model 7-2810 F FM/AM Portable Radio, published by General Electric Company, Audio Electronics Technical Services, Utica, New York, U.S.A., June 1976.

Subsequent reference to the above-tabulated literature will be simply AA, BB et cetera.

In particular, the invention provides improvement over the FM/AM detector circuit disclosed in BB, and also in CC, in respect to bias and output voltage variations in AM and FM operation. While BB and CC disclose an AM-FM detector circuit of highly satisfactory operation well suited for integrated circuit (IC) fabrication, unavoidable discrepancies in the processing of the IC's create differences in the electrical properties of the IC's active and passive components from one circuit to another, which are the result of differences relating to geometry of the semiconductor components. These discrepancies, however slight, tend to provide bias and output voltage variations which reduce the so-called yield, i.e. the percentage or ratio of the fabricated circuits falling within acceptable limits, to the total number of fabricated circuits. In addition, in operation the detector circuit of BB or CC may exhibit additional bias and output signals variations with changes in ambient temperature. It is difficult to compensate integrated circuits for temperature instability, which results in drifts even in FM operation, and perhaps even to greater extent in AM operation. The AM-AGC (automatic gain control) voltage has a tendency to drift with temperature change, which requires a tightening of the tolerances and thereby acts to further reduce the yield.

It is therefore an object of the invention to provide an improved AM-FM detector circuit wherein bias and output voltage variations due

The capability of handling either AM or FM signals by the detector circuit, and also by the IF amplifier, is achieved by sharing of circuit components for the AM and FM operations.

In this specification reference will be made to the following literature:

to unavoidable IC process changes and due to ambient temperature changes, are significantly reduced.

The AM-FM detector of the present invention meets this objective. It is, generally speaking, organized in a manner similar to that of BB or CC, and as such it comprises at its input, a differentially connected emitter follower pair which in FM operational use functions to pass the greater, or more dominant of two FM-IF input signals, which are phase displaced at the FM-IF carrier frequency by 90°, with the phase displacement varying continuously about the 90°, in accordance with the modulation. In AM operational use, that emitter follower pair operates on incoming AM-IF signals as a full-wave peak rectifier. Onward of the emitter follower pair is an FM-channel, which comprises a zero crossing detector, and an output stage which provides the recovered audio modulation and an AFC (automatic frequency control) signal.

The emitter-follower pair, and the FM channel hereof incorporate substantial improvements vis-a-vis BB or CC, in the interest of stability. The AM channel hereof incorporates substantial departure from that of BB or CC, also in the interest of stability. As such it features a linear differential amplifier, which feeds into the same output amplifier as the FM channel; the latter output amplifier is fully active in both FM-mode and AM-mode, and in the latter mode provides the recovered audio and an AGC signal.

Other objects, advantages, and features of the invention will appear in the following, more detailed specification which includes the appended Claims, with reference to the accompanying drawings, in which:

Figure 1 is a block diagram of a superheterodyne radio receiver circuit embodying the inventive AM-FM detector circuit;

Figure 2 is a primarily schematic and partly block circuit diagram of the AM-FM detector circuit, and of associated circuitry in accordance with the invention;

Figure 3 is a series of graphs employed in the description of the circuit of Figure 2.

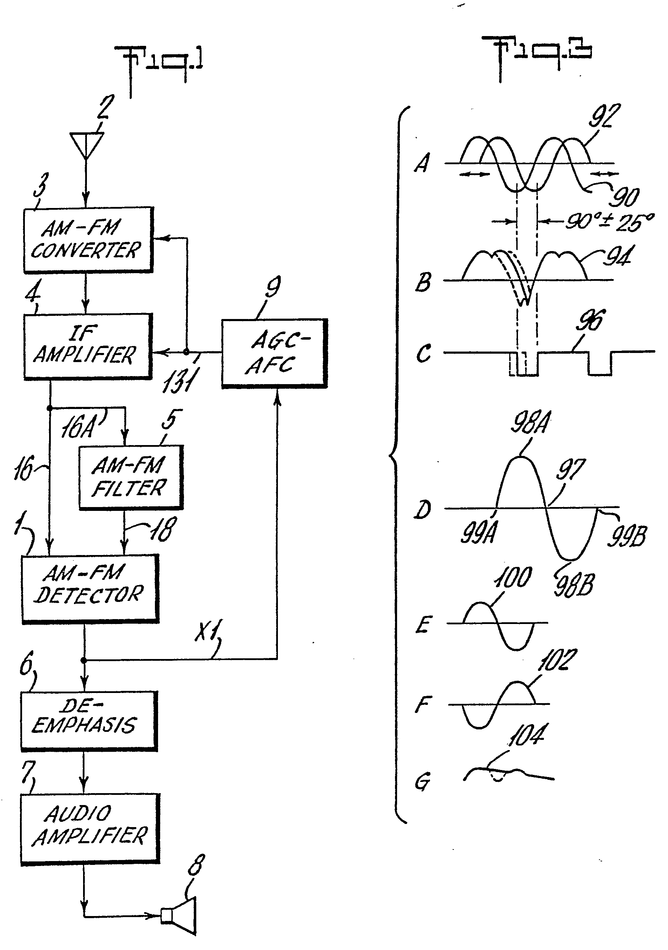

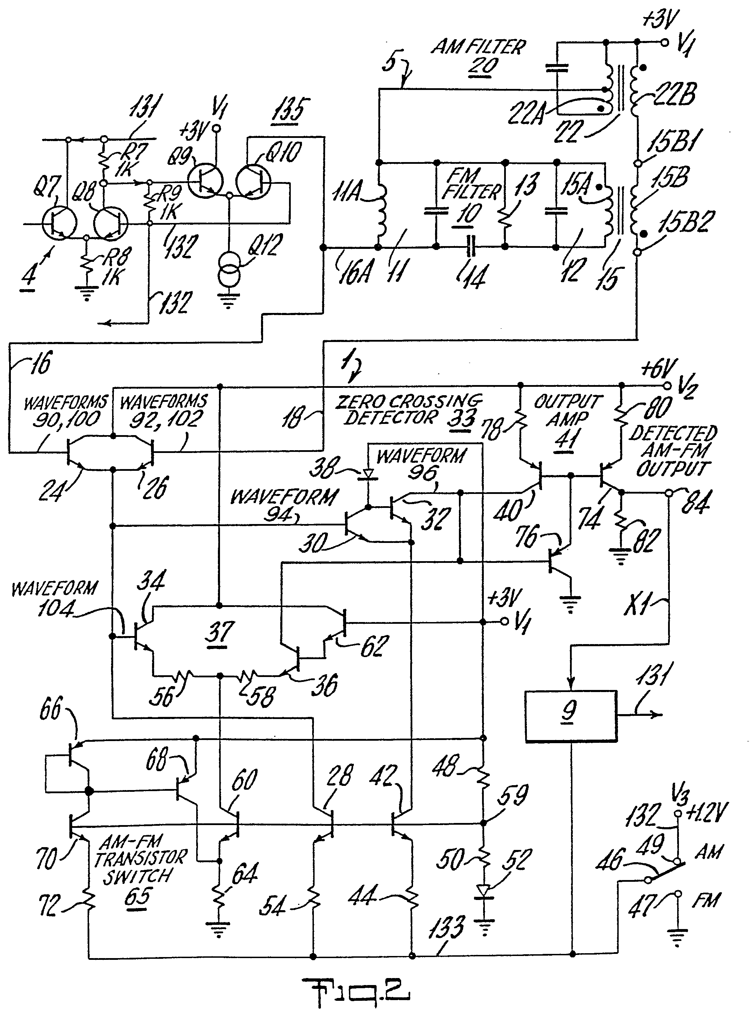

With reference to Figure 1, shown therein is the FM-AM detector circuit which is the subject of the present invention, incorporated in a typical superheterodyne radio receiver circuit, the components of which are presented in block form. An antenna arrangement 2 is capable of receiving FM or AM signals at their respective radio frequencies (RF), and couples them to an AM-FM converter 3, which converts the signals to the intermediate frequency (IF) for AM or FM, depending upon the selected mode of operation. The IF signal, having a center frequency nominally of 455 KHz for AM and 10.7 MHz for FM, is coupled to an IF amplifier 4 which provides adjacent channel attenuation and functions to amplify the AM-IF signals or the FM-IF signals. AM-FM converter 3 and IF amplifier 4 may be known components such as disclosed in AA or CC. Indeed, since the CC disclosure incorporates the disclosures of AA and BB, with some improvements to the radio receiver circuits shown in AA and BB, it will be convenient to assume that the block diagram of Figure 1 hereof and the circuitry of Figure 2 hereof, are those of CC with the exception of the FM-AM detector circuit which is the subject of the present invention, and with some other minor exceptions pointed out hereinafter. The disclosure of CC is incorporated herein by reference. One such minor exception is given here; it concerns the AM-FM converter 3. The AM portion of the converter 3 may be assumed to be that of CC. As to the FM portion of the converter 3, it is remarked here that the FM converter is usually "off" the IC chip, even to the extent that its transistors and resistors are off the IC chip. Therefore, a variety of such FM converters have been utilized, depending upon the particular kind of radio receiver desired (table model, portable etc.). Hence, the FM converter within block 3 of Figure 1 could be that of CC or that of AA or that of DD, or other similar FM-converter.

The output of the IF amplifier 4 is coupled via line 16 to one input of the AM-FM detector 1, and via branch line 16A to the input of the AM-FM filter 5. The lines 16 and 16A carry the same signal in either FM or AM operation. The filter 5, at its input contains an FM parallel resonant circuit (significant in FM insignificant in AM) and an AM parallel resonant circuit (significant in AM, insignificant in FM). These resonant circuits insure that the signal on line 16 (and also on line 16A) is maximized in amplitude. The signal on line 16, i.e. ingoing to the AM-FM detector 1, is hereinafter referred to as the "in-phase signal" or being of "0° phase" or "reference phase" relative to the signal outgoing from the AM-FM filter and applied as second input signal to the AM-FM detector 1.

The AM section of the filter 5 produces its output signal—ingoing via line 18 into the second input of the detector 1—as a 180° phase shifted version of the in-phase signal on line 16. The FM section of the filter 5 produces its output signal—ingoing via line 18 into the second input of the detector 1—with a phase shift, relative to the in-phase signal on line 16, which is a linear function of the instantaneous frequency of the FM-IF signal; at the nominal center frequency of 10.7 MHz the phase shift is about 90°.

The detector circuit, which will be described in detail when considering the schematic circuit diagram illustrated in Figure 2, operates to automatically detect either the AM or FM/IF signal. The circuit is particularly suited to IC fabrication for providing improved yields through significantly reduced bias and output voltage variations in the presence of unavoidable IC process and ambient temperature changes, and also provides extended dynamic range of AM signal response. The detected signal at the output of the detector 1 is coupled to a de-emphasis network 6 and thence to an audio amplifier 7 and speaker 8. The detected signal is also coupled via line X1 to an automatic gain control-automatic frequency control (AGC-AFC) network 9. The network 9 is referred to in AA and BB as "bias supply" or "controlled current source" or "adjustable current source" or "AFC-AGC amplifier". For present purposes, the network 9 may be assumed to be as composed of the following components of CC: transistors Q11, Q17, Q22, Q23 and the circuitry associated with these transistors.

The output of the AGC-AFC network or amplifier 9 is coupled via "primary bus" 131 to the IF amplifier 4 and the converter 3, to effect automatic gain control in AM operation and automatic frequency control in FM operation. Also to apply greater input current and voltage to the IF amplifier 4 in FM operation than in AM operation, and hence provide greater IF amplification in FM operation than in AM operation.

The primary bus 131 corresponds to the primary bus 31 of CC; for other components hereinafter mentioned and identified by reference numeral which is in the range of from 120 to 199, it may be assumed that these correspond respectively to components of CC having the same two least significant digits.

The deemphasis network 6 is the same as that shown in BB or CC, as will be explained hereinafter. The audio amplifier 7 may be of conventional circuitry; however, if it is desired to provide the audio amplifier in integrated circuit format, integrated together with the other integrated circuit components of Figure 1 on a single IC chip, the audio amplifier may be of the type shown in U.S. Patent Specification No. 4,025,871 Peil or its corresponding British Patent Specification No. 1,485,682.

Referring to Figure 2, shown therein is the penultimate stage (Q7, Q8) and the final stage 135 (Q9, Q10) of the IF amplifier 4, which are replicas of the corresponding IF amplifier stages of CC, and utilizing the same identification as in CC. As to Q7, Q8 noteworthy here are the collector circuit connections to the primary bus 131, the secondary bus 132, these being typical also for still lower preceding stages, plus the feed-back resistor R9 to the base of Q8, which is the origin of the secondary bus 132. As to the final stage 135, the current source Q12 of Figure 2 hereof is intended not only to reflect the transistor Q12 of CC, but also the circuitry associated with transistor Q12 of CC. Input IF signal from the preceding IF amplifier stage Q8 is applied to the base of Q9, whereas the base of Q10 is connected to the secondary bus 132.

In AM operation, the bus 132 provides AGC voltage to the bases of Q8 and Q10 as well as to the bases of some transistors of the preceding IF amplifier stages. In FM operation, the bus 132 provides higher dc potential to the bases of Q8 and Q10 and of other transistors, to match the higher d.c. potential provided to the bases of Q7 and Q9. The manner of operation of the IF amplifier is more fully described in AA. There is one difference as between the final stage 135 hereof and the final stage 35 of CC. As shown in Figure 2 hereof, the transistor Q9 has its collector supplied by the d.c. voltage $V_1$ which is +3 volts, in contrast to CC where the collector supply voltage for Q9 is +6 volts. The reason for this is that Q10 hereof is also supplied by the +3 volts as will be presently seen, in contrast to Q10 of CC which is supplied by +6 volts. The usage of the lower +3 volts for the final IF amplifier stage 135, rather than +6 volts, does not affect the performance of the IF amplifier per se, nor in a direct sense. However, the usage of the +3 volts for supplying the transistors Q9 and Q10 has an important impact on the operation of the FM/AM detector 1 of the present invention, which then in an indirect way affects the performance of the entire IF amplifier 4 in a beneficial manner, as will be described hereinafter.

The AM/FM filter 5 is essentially the same as shown in DD or BB, and in effect is also equivalent to the AM/FM filter shown in CC.

As shown in Figure 2, the FM filter section 10 of filter network 5 includes a first parallel resonant tank circuit 11 at the input and a second parallel resonant tank circuit 12 shunted by a resistor 13 at the output. Input and output are capacitively coupled by a capacitor 14 which cooperates with resistor 13 and circuit 12 to produce the requisite 90° phase shift at the resonant frequency of 10.7 MHz. The collector of Q10 is connected to the conductor 16, and to the inductor 11A of the input tank circuit, the output of the FM filter section being coupled via a transformer 15 to the conductor 18. The AM filter section 20 includes a transformer 22 having a tuned primary winding 22A, with the untuned secondary winding 22B providing a phase inverting output connection to conductor 18. The +3 volts d.c. is supplied to the collector of Q10 via the primary winding 22A of the AM transformer 22, thence through its center-tap, thence through the input winding 11A of the FM resonant circuit. The +3 volts d.c., and also the IF signal (FM or AM) appearing at the collector of Q10, are propagated via conductor 16 to the base of transistor 24, which in terms of Figure 1 is the first input of the AM-FM detector 1. The +3 volts d.c. is also passed via the serially connected secondary windings 22B and 15B of the AM transformer, and the FM transformer, and via conductor 18, together with the phase shifted IF signal (FM or AM) to the base of transistor 26, which in terms of Figure 1 is the second input of the AM-FM detector 1. The "dots" associated with the windings 22A, 22B and 15A, 15B are in line with the usual dot convention. As to the AM transformer 22, they reflect the required phase reversal (180° phase shift). As to the FM transformer, the dots have special significance discussed hereinafter. The filter sections 10 and 20 provide the phase shift functions required for the hereinafter described detection process, as well as additional adjacent channel attenuation.

The FM-AM detector circuit 1 has at its input a differentially connected emitter follower pair of the previously mentioned transistors 24 and 26 employed in both AM and FM signal detection. The inphase IF signal is applied to the base of transistor 24, and the phase shifted signal is applied to the base of transistor 26. The collectors of these transistors are joined and connected to a second regulated d.c. voltage supply $V_2$ which is typically +6 volts, i.e. of substantially greater d.c. voltage than $V_1$ applied to their bases, for reasons to be considered hereinafter. Note that in BB or CC, the bases and collectors of their corresponding transistors were all supplied by +6 volts; this points to an important distinction in the generally similar differentially connected emitter follower pairs. As in BB or CC, the emitters of transistors 24 and 26 are joined and connected to the collector of a first current source comprising NPN transistor 28, to the base of an NPN transistor 30 which with NPN transistor 32 comprises a zero crossing detector 33 that is operative during FM detection, but the devices 28 and 33 differ substantially from the corresponding devices of CC or BB. Moreover, and this is new vis-a-vis BB or CC, the commoned emitters of transistors 24 and 26 are additionally connected to the base of an NPN transistor 34, which with NPN transistor 36 comprise a linear differential amplifier 37, which provides a first stage preamplification of the AM audio signal, and of the dc AGC signal.

The emitter of the first current source transistor 28 is connected via a current determining resistor 54 to a "mode switching control bus" 133, which in turn is connected to a mode setting switch 46 having one fixed contact 47 at ground for FM operation, and another fixed contact 49 at a d.c. voltage $V_3$, for example +1.2 volts, in AM operation. The dc voltage $V_3$ may be fixed at typically +1.2 volts, as is shown in AA or BB, or it may be provided from the secondary bus 132 (as in CC), in which case the mode switching control bus 133 corresponds to the mode switching control bus 33 of CC.

The zero crossing detector transistor 30 has its collector electrode connected through a diode 38, poled as shown, to $V_1$ and to the base of transistor 32, the collector of which is coupled to the collector of PNP transistor 40 of an output amplifier network 41. The emitters of transistors 30 and 32 are connected to the collector of a second current source comprising NPN transistor 42. The dual connections between transistors 30 and 32 provide for regenerative, trigger-type action. Note that the collectors of transistors 30 and 32 are isolated, i.e. not intercoupled by a resistance, as in BB or CC. The emitter of transistor 42 is connected through a current determining resistor 44 to the mode switching control bus 133. Connected to a temperature stable reference voltage reference point 59 are the bases of the following transistors: first current source transistor 28, second current source transistor 42, and third current source transistor 60 discussed hereinafter, an an "FM-AM switch" transistor 70 also discussed hereinafter. The temperature stable reference point 59 is provided by a pair of resistors 48 and 50 and a temperature compensating diode 52 (poled as shown), one side of the resistors being connected to the regulated dc voltage supply $V_1$ and the other side connected through diode 52 to ground. The reference voltage point 59 is established at the junction of resistors 48 and 50. Current sources or switching transistors, generally speaking somewhat analogous to transistors 28, 42 and 60, appear also in BB and CC, but important differences exist.

The zero crossing detector 33 generates output current pulses with a duty cycle as a function of FM signal modulation. Transistors 30 and 32 have current conduction properties closely matched to each other and to those of emitter pair transistors 24 and 26, which in IC fabrication is done through precise control of the base-emitter junction geometry of the devices. In the present circuit the transistors are all of minimum junction geometry, except as otherwise noted. Minimum junction geometry, or minimum geometry should be understood to mean the minimum area assigned to the transistor junctions, for a given IC process, necessary to provide requisite small signal properties on the transistor. As will be more fully described, by setting the currents in current source transistors 28 and 42 through resistors 54 and 44, respectively, which currents are made temperature stable, and by controlling device geometry, the current ratio between transistors 30 and 32 can be properly established to insure that with the radio receiver set to the FM-mode, there is no steady-stage shift of the dc voltage level on the AFC line X1 (Figures 1 and 2) upon transfer from any one, to any other, of the following conditions:

(1) The "static" condition of "no FM-IF input signal is present". This static condition exists in an operational radio receiver, when the receiver is detuned from all broadcast stations. The static condition is also deliberately produced during testing and line-up of the radio receiver as an important criterion for these purposes, as will be evident hereinafter.

(2) A first "dynamic" condition of unmodulated FM-carrier (10.7 Mhz) injected into the FM-AM detector 1, and hence propagated via transistors 24 and 26 to transistors 30 and 32. This first dynamic condition is an important criterion for testing and line-up of the radio receiver. In actual FM operational use, the first dynamic condition might exist when the radio receiver is tuned in to receive an FM broadcast station, which right then there is transmitting, but is observing a brief "audio silence", as a symbol of mourning for example.

(3) A second "dynamic" condition of modulated FM-carrier (10.7 Mhz) injected into the FM-AM detector, and hence similarly propagated. This second dynamic condition exists in an operational radio receiver, when it is tuned into receive a broadcast station so that the broadcast audio signal is reproduced in the loud speaker. The second dynamic condition is produced for testing and line-up purposes, where it is an important criterion, by injecting into the FM-AM detector 1, FM-IF carrier (10.7 Mhz) frequency-modulated with a "sweep-signal", i.e. one that repeatedly sweeps through the useful AFC-band, as will be explained hereinafter.

Maintaining the same dc voltage level on the AFC line X1 is important in regard to (1) maintaining stability in the AFC loop, and consequently maintaining stability of tuning, and indeed maintaining stability of the receiver, and (2) minimizing audio distortion in FM-reception. This will be evident from the subsequent description. The circuit configuration of the zero crossing detector network 33 ensures that the current ratio between transistors 30 and 32 remain constant and that audio distortion be minimized even in the presence of any changes in value of total current carried by transistors 30 and 32, which changes may occur due to IC process variations or ambient temperature changes.

With respect to linear differential amplifier 37, its circuit configuration provides the generation of an output current that accurately reflects the AM signal modulation independently of IC process variations and ambient temperature changes. Transistors 34 and 36 have matching current condition properties.

Their emitters are coupled through the series connection of equal value resistors 56 and 58 (each typically 3 K), the junction of which is coupled to the collector of the third current source NPN transistor 60. The collector of transistor 34 is connected to the +6 volt line $V_2$ and to the collector of bias current NPN transistor 62, the base of which is connected to the +3 volt line $V_1$ and the emitter of which is connected to the base of transistor 36. The collector of transistor 36 is connected to the collector of PNP transistor 40 of output network 41. Transistor 62 has a base-emitter junction area twice that of transistors 24 and 26 so as to provide equal current conduction in transistors 34 and 36 in the absence of AM-IF signal. The emitter of transistor 60 is connected through current determining resistor 64 to ground, and its base is connected to the reference point 59 as previously stated. The emitter of transistor 60 is also connected to an AM-FM transistor switch arrangement 65 comprising PNP transistors 66, 68 and NPN transistor 70. Transistor 68 has twice minimum junction geometry. Transistor 66 is connected as a diode. The emitters of transistors 66 and 68 are connected to the +3 volt line $V_1$. The base of transistors 66 is connected to its collector to form the diode, and also to the base of transistor 68 and to the collector of transistor 70. The collector of transistor 68 is connected to the emitter of transistor 60. The emitter of transistor 70 is connected through a resistor 72 to the mode switching control bus 133, as previously stated.

The output amplifier network 41 comprises a first PNP input transistor 40, a current multiplier or output PNP transistor 74, these two having matching current conduction properties, and a second PNP input transistor 76. The three PNP transistors 40, 74 and 76 are active in FM mode as well as in AM mode, noting that connected together are the collectors of FM-zero crossing detector transistor 32 and of AM-differential amplifier transistor 36. In addition to other functions described hereinafter, the transistors 40 and 76 perform the following "d.c. level shifting" function. The base-collector junction of transistor 40 constitutes a first diode which couples to the base of the output transistor 74 the collector of either transistor 32 (in FM) or of transistor 36 (in AM). The base-emitter junction of transistor 76 constitutes a second such coupling diode, which is matched to the first coupling diode but poled in reverse thereto. Thus with either more positive or more negative voltage at the collector of either transistor 32 or transistor 36, transmission to the base of transistor 74 occurs via one coupling diode or the other, but with dc level shaft which stems from the inherent voltage difference across one or the other coupling diode.

The transistor 74 has a base-emitter junction area twice that of transistor 40, and hence provides a current multiplication of two in the output current carried by transistor 74. The emitters of transistors 40 and 74 are connected through resistors 78 and 80, respectively, to the +6 volt line $V_2$. Consonant with the current multiplication of two, the resistors 78 and 80 are in the ratio 2:1, being typically 1.2 k and 600 ohms. The bases of these transistors are joined and connected to the emitter of transistor 76, the collector of which is coupled to ground. The base of transistor 76 is coupled to the collectors of transistors 36, 32 and 40. The base to emitter capacitance of transistor 74, and the integrative effects associated with the drift time required for carriers to reach the collector of transistor 74, provide integration of the FM output current, and to a small extent of the AM output current. The output current is taken from the collector of transistor 74, which is connected through an output resistor 82 to ground and to output terminal 84 of the detector circuit from which the detected AM or FM audio signals are derived, and from which the AM-AGC dc voltage or the FM-AFC dc voltage are applied (together with the detected audio signals) via line X1 to the AFC-AGC amplifier 9. In correspondence with the AFC-AGC amplifier of CC (its Q17, Q11, Q22, Q23), or of BB (its transistors Q15, Q16, Q17 and its diode D6), the emitter of one mode-switching transistor within the block 9—corresponding to Q23 of CC or Q17 of BB—is connected via a resistor (internal to block 9) to the mode switching line 133.

The matters set forth in this and in the next few paragraphs, will be more evident from the subsequent description of the operation of the detector 1 in AM-mode and in FM-mode. In *AM-mode,* of the transistors of the detector 1 shown in Figure 2, the following are active: input transistors 24 and 26, linear differential amplifier transistors 34, 36 and 62 as well as their current source transistor 60, and output amplifier network transistors 40, 76 and 74. All other transistors are inactive.

The *AM-AGC* sense of the detector 1 is as follows. Assume that initially the radio receiver is tuned to receive a relatively strong AM-RF broadcast signal. This requires that the voltage on the primary bus 131 attain a minimum (composite static plus dynamic AGC) positive value, so that the gain of the IF amplifier 4 and of the AM section of the AM-FM converter 3 be minimum; see the description of AA.

Next assume that the receiver is tuned to receive a very weak AM-RF broadcast signal. This requires that the composite static plus dynamic AGC voltage on the primary bus 131 should attain a relative high positive value. The maximum positive value on primary bus 131 is attained in the "static" AM condition, i.e. the radio receiver is turned on, but is detuned from all broadcast stations, so that no AM-RF signal and hence no AM-IF signal is present; again see AA. In consequence of such weak AM-RF signal reception, the AM-IF carrier signal developed by the IF amplifier would be relatively small, and hence at the commoned emitters of the input transistors 24 and 26 there would be developed a dynamic AGC dc voltage of relatively small positive value, and of course the demodulated audio signal would be of relatively small amplitude. The linear differential amplifier 37 preserves the sense of the dynamic AGC dc signal so that at the collector of transistor 36 there is developed a positive dynamic AGC voltage of relatively small value. The output PNP transistor 74 at its collector (i.e. output terminal 84 and line X1) however, inverts the sense, so that the dynamic dc AGC voltage developed thereat is negative and is of relatively small magnitude. Hence the composite static plus dynamic AGC dc voltage on line X1 is relatively high. Since for weak AM signal the composite voltage on primary bus 131 is required to be relatively highly positive, it follows that the AGC-AFC amplifier 9 should produce an even number of sense-inversions; this is the case for the AGC-AFC amplifier of BB or CC, which produce two such inversions.

In *FM-mode*, of the transistors of the detector 1 shown in Figure 2, the following will be *inactive*: AM linear differential amplifier transistors 34, 36 and 62, as well as their current source transistor 60. All other transistors will be *active*. The FM-AFC sense of the detector is as follows. Assume first that the radio receiver is turned on, but is detuned from all FM-broadcasting transmitting stations; this corresponds to the static FM condition ("condition 1") previously mentioned. Certain static level voltages exist at the collector of zero-crossing detector transistor 32, and at the collector of the PNP output transistor 74, i.e. at terminal 84 and line X1. Correspondingly, there exists a static level voltage on primary bus 131, which may be typically +2.4 volts as described in AA or DD.

Next assume that the radio receiver is turned on, and is tuned to receive an FM-RF signal from a broadcast station, which right then and there is transmitting, but is observing a brief "audio silence", as a symbol of mourning for example. Assume further, that the initial tuning is perfect, so that the frequency of the FM local oscillator is exactly 10.7 Mhz above the FM radio frequency. Under these circumstances, the IF signal injected into the detector 1 is exactly 10.7 Mhz, and moreover is unmodulated; this corresponds to the aforementioned first dynamic FM-condition ("condition 2") utilized for test purposes. In consequence, there will be developed at the commoned emitters of the input transistors 24 and 26, a signal having the waveform shown in Graph B of Figure 3 (solid line curve 94), which is negative (relative to the horizontal time axis) for 25%, and positive 75%, of one cycle of the 10.7 Mhz IF. In consequence, at the collector of the zero-crossing detector transistor 32 there is developed a signal having the waveform shown in Graph C of Figure 3 (solid line curve 96), i.e. a narrow negative pulse for 25%, and a wide positive pulse of 75% of one cycle of the 10.7 Mhz IF.

The waveform 96 necessarily contains a d.c. component, which nevertheless has the same value as in the FM static condition, and in consequence the terminal 84 (line X1) will carry the same dc potential as it had in the FM static condition ("condition 1"), and hence the primary bus 131 will also be at its static potential of say +2.4 volts; this is important out of considerations of maintaining stability of the IF amplifier 4, and indeed stability of the radio receiver, as has been stated before. Prevalence of the same dc levels in "condition 1" and in "condition 2", for the collector of transistor 32, for the collector of transistor 74 (line X1), and for primary bus 131, is attained when the receiver is aligned at the factory, by adjustment or tuning of FM-transformer (windings 15A and 15B); the alignment procedure is explained hereinafter.

Continue to assume perfect tune-in to the FM-RF broadcast station, but assume that audio silence has ended, so that the FM detector 1 is now producing audio output signal, which however necessarily has no dc component. This is the aforementioned second dynamic condition for FM mode ("condition 3"). It is quite evident, that the dc conditions given in the immediately preceding paragraph still prevail, so that again the dc levels are the same as in the static condition ("condition 1") for the collector of transistor 32, for line X1, and for primary bus 131 (typically +2.4 volts).

Next, assume again tune-in to an *FM* broadcast station, but with imperfect tuning, e.g. the initial tune-in causes the FM local oscillator frequency to be lower than required for perfect tune-in, and hence the FM-IF injected from the IF amplifier 4 into the detector 1, is less than 10.7 Mhz, say 10.6 Mhz. The consequent events described in this and the following two paragraphs, are predicated on the "dot connection" for the FM transformer as shown in Figure 2. Again assume at first FM-RF transmission, but observance of audio silence. Under these conditions, the negative excursions in Graph B (waveform 94) will be wider than 25%, and the positive excursions will be narrower than 75% (of one cycle of 10 Mhz), than in the case of perfect tune-in. Similarly, in Graph C (waveform 96) the negative pulses will be wider than 25%, and the positive pulses will be narrower than 75%, than in the case of perfect tune-in. Hence, the dc voltage at the collector of transistor 32 will be lower than in the static condition, and lower than in the condition of perfect tune-in. At the collector of PNP output transistor 74, i.e. at terminal 84 or line X1, there occurs an inversion of the dc AFC signal sense; the dc voltage is higher than in the static condition. Since the AFC-AGC amplifier 9 subjects the AFC dc signal to two inversions (as stated above), the voltage on primary bus 131 will analogously be greater than +2.4 volts. Again assuming imperfect tune-in, but now presence of audio modulation, it is evident that the AFC dc relations are nevertheless the same, since the audio does not affect the dc relations.

The behavior described in the immediately preceding paragraph, is reflected by Graph D of Figure 3, which is the "'S-curve" or "FM-discriminator characteristic" produced by the FM-detector 1, at the output terminal 84. The S-curve is obtained by sweep-frequency modulating a 10.7 Mhz FM-IF test signal carrier, injecting the so modulated signal into the detector 1, i.e. subjecting it to the aforementioned second dynamic condition ("condition 3"), and observing the resultant output on a cathode ray oscilloscope, which is connected to terminal 84; this procedure is explained in greater detail in DD. The following comments are noteworthy in regard to the S-curve: (1) The horizontal axis is not merely indicative of frequency, but also reflects the dc level at terminal 84 in the static FM condition ("condition 1") or the first dynamic FM condition ("condition 2"), (2) The S-curve is linear within ±75 khz of the 10.7 Mhz point 97, this linear range being required to avoid audio distortion. (3) The S-curve is symmetrical about the 10.7 Mhz point 97; this is desirable to achieve the same dc voltage at terminal 84 in the static condition as in the two dynamic conditions. Symmetry implies that the positive characteristic in the second quadrant be a mirror image of the negative characteristic in the fourth quadrant. (4) The peaks 98A and 98B are each separated by about 200 Khz from the 10.7 Mhz point 97. (5) The end points 99A and 99B, which define the limits of the useful pull-in range or hold-in range, are each separated by about 400 Khz from the 10.7 Mhz point 97. To achieve such wide band for AFC purposes, a resistor might be inserted in shunt with inductor 11A, as shown in DD.

Recall the circumstances set forth two paragraphs hereinabove, i.e. the unmodulated *FM*-IF signal is at less than 10.7 Mhz, so that the voltage on the primary bus 131 is increased above the +2.4 volt value. To increase the frequency of the FM local oscillator (within block 3), so that the IF be forced to 10.7 Mhz, that FM local oscillator must have the characteristic of increased voltage on primary bus 131 produces increased FM local oscillator frequency, which is the case for the two rather dissimilar FM local oscillators of CC and DD.

However, radio receivers of the kind contemplated herein, often contain *FM* local oscillators which have exactly the opposite FM-AFC response, namely assuming that the FM local oscillator frequency is two low, and hence the FM-IF lower than 10.7 Mhz, voltage on the primary bus 131 should be *decreased,* so that the local oscillator frequency increase, and the FM-IF be forced back to 10.7 Mhz; an example of such opposite FM-AFC response is the FM local oscillator of AA, this despite its apparent similarity to the FM local oscillator of DD. The opposite FM-AFC response is easily implemented in the arrangement of Figure 2, simply by connecting conductor 18 to the terminal 15B1 instead of terminal 15B2, and vice versa for the conductor shown to be incoming (in Figure 2) to the terminal 15B1 of the FM-transformer secondary 15B. When such interchange of conductors is made, the following will be true for the conditions of FM local oscillator frequency too low, and the FM-RF broadcast station observes "audio silence": (1) In Graph B, the narrow negative portions are narrowed and its position portions are widened, rather than vice versa (as before). (2) In Graph C, the narrow negative pulses are narrowed, and its wide positive pulses are widened, rather than vice versa (as before), and the dc voltage at the collector of transistor 32 is more positive, rather than more negative (as before). (3) The voltage at the terminal 84 (i.e. line X1) is decreased rather than increased (as before). The S-curve (Graph D) is accordingly inverted, being positive in the first quadrant and negative in the third quadrant. The subsequent description will be primarily for the dot connection as actually shown in Figure 2, i.e. the conductors incoming to terminals 15B1 and 15B2 being as shown in Figure 2, and the consequences of interchange of these conductors can be readily inferred.

Before proceeding to describe the operation of the circuitry of Figure 2 in detail, the description of the structure of that circuitry will now be completed. The resistor 82 has a value typically of 7.5 Kohms (as is the case for the corresponding resistors of CC or BB); externally of the ingerated circuit chip which Figure 2 reflects, the resistor 82 is shunted by a 0.01 microfarad capacitor (as also shown in CC or BB) to constitute the de-emphasis network 6 of Figure 1. The primary and secondary busses 131, 132, and the mode switching control bus 133, are bypassed to ground by off-the-IC-chip capacitors (not shown) which may be assumed to have the same values as in CC. The entire arrangement of Figure 2 may be assumed to be integrated together, with the exception of the mode-switch 46 and the AM-FM filter 5.

In one exemplary embodiment of the AM-FM detector circuit of Figure 2 the following circuit components and values were employed which are given principally for the purpose of illustration and are intended not to limit the invention:

| Transistors | 24, 26, 28, 30, 32<br>34, 36, 42, 60, 70 | Minimum Geometry NPN |
| | 40, 66 | Minimum Geometry Lateral<br>PNP |
| | 68, 74 | Two Times Minimum<br>Geometry Lateral PNP |
| | 62 | Two Times Minimum<br>Geometry NPN |
| | 76 | Minimum Geometry<br>Substrate PNP |
| Diodes | 38, 52 | Minimum Geometry NPN Type |
| Resistors | 56, 58 | 3 Kohms |
| | 78 | 1200 ohms |
| | 80 | 600 ohms |
| | 82 | 7.5 Kohms |
| | 48 | 6 Kohms |
| | 50 | 1 Kohm |
| | 44 | 870 ohms |
| | 54 | 1.3 Kohms |
| | 64 | 1.35 Kohms |
| | 72 | 930 ohms |
| Voltage Source | $V_1$ | +3 volts dc |
| | $V_2$ | +6 volts dc |
| | $V_3$ | +1.2 volts dc |

## Operation-FM mode

Referring to the operation of the detector circuit of Figure 2, the basic detection operation is the same as in BB and is fully described therein. In this discussion primary emphasis will be placed on the operation insofar as the present invention is concerned. During *FM* signal detection the mode select switch 46 is at ground which causes first and second current source transistors 28 and 42 to conduct since the reference voltage at the junction 59 of resistors 48 and 50 is at a positive value which is determined by $V_1$ and by the voltage drops across resistors 48 and 50, and diode 52. In addition, transistors 66, 68 and 70 (contained in the switch network 65) conduct; this develops a voltage across resistor 64 that prevents the third current source transistor 60 from conducting. Accordingly, the "AM" differential amplifier 37 is made inactive. Conduction of the current source transistors 28 and 42 make the zero crossing detector 33 active and determines the currents flowing in it and in the differentially connected emitter follower pair of transistors 24 and 26. The inphase FM input signal coupled to the base of transistor 24, having the waveform shown by curve 90 in Graph A of Figure 3, and the phase shifted FM input signal coupled to the base of transistor 26, having the waveform shown by curve 92 in Graph A, cause one or the other of these transistors 24, 26 to be conductive in accordance with the greater or predominant one of the input waveforms 90, 92 to provide an output waveform as shown by curve 94 in Graph B. The output waveform 94 is a voltage appearing at the commoned emitters of transistors 24 and 26; it has variable width and variable amplitude positive and negative going portions.

Significantly, the width or duration of the negative going portions is proportional to the instantaneous frequency deviation. The negative going portions are approximately 90° wide at zero frequency deviation (10.7 Mhz), corresponding to a 90° phase displacement of the second input signal (base of transistor 26), from the first input signal (base of transistor 24) varying between 65° to 70° for negative 75 khz frequency deviation, and 110° to 115° for positive frequency 75 Khz deviation from 10.7 Mhz, for the wiring of the incoming conductors to secondary winding 15B as shown in Figure 2 (and vice versa, were these incoming conductors interchanged, for the purpose of accommoding the FM local oscillator of for example AA, as previously mentioned).

As a result of the regenerative, trigger-type action of transistors 30 and 32, the zero crossing detector 33 provides, at very low input signal levels more or less linear amplification, but provides a limiting action even at below normal signal levels. Thus, the negative going portions of waveform 94 are converted into corresponding variable width rectangular pulses of current, such as shown by waveform 96 in Graph C, having a width or duty cycle also proportional to the instantaneous frequency deviation and an amplitude that is constant or limited; the latter proportionality and the latter limiting are necessary to avoid distortion in the audio signal.

Current condution in the transistors of the zero crossing detector for the static FM condition ("condition 1") is established by the first and second constant current sources of transistors 28 and 42, respectively, and the application of the same +3 volts voltage $V_1$ to the bases of transistors 24 and 26 and to the anode of diode 38. The sum of the base-emitter voltage drops of transistors 26 and 30 must equal the sum of the voltage drops across diode 38 and the base emitter of transistor 32. Since the current flowing in diode 38 must substantially equal the current in transistor 30, by making the junction area of diode 38 and the base-emitter junction area of transistors 24, 26, 30 and 32 equal, the voltage drop across diode 38 must equal the base-emitter voltage drop of transistor 30. Thus, the base-emitter drops of transistors 26 and 32 must be equal and the currents flowing in these transistors must be equal. By setting the currents in the first and second current source transistors 28 and 42 to some prescribed value, a desired current ratio between the current in transistors 30 and 32 can be readily established, so that the dc or average output current in the network 41 does not change in the transitions from the static to the first dynamic to the second dynamic FM condition. This assures generation of the symmetrical S curve at the output terminal of the detector, shown in Graph D. In the exemplary circuit under consideration, the static currents in the first and second current sources (28, 42) were set at approximately 0.4 I and 0.8 I, respectively, with 0.2 I current in each of transistors 24 and 26, 0.6 I current in transistor 30 and 0.2 I current in transistor 32. But the current source (28, 42) emitter resistors 54, 44 are in the ratio of 6:4, being typically 1.3 k and 870 ohms, because of the unequal base-emitter volt drops in transistors 28, 42, due to their unequal currents.

The currents in first and second constant current source transistors 28 and 42 are temperature stable to a high degree due to the coupling of their bases to the junction 59 of resistors 48 and 50 of the temperature compensation network. Any change in voltage due to change in ambient temperatures across the base-emitter junctions of the current source transistors 28 and 42, which have a negative temperature coefficient, is compensated by a matching negative temperature coefficient of diode 52. Any change in resistance due to change in ambient temperature of the current source emitter resistors 54 and 44, which have a positive temperature coefficient, is also substantially compensated by inherent similar resistance changes in the circuits involved. While small changes in absolute current can be tolerated, faithful, distortion free detected output signals depend primarily on the proper ratio of the currents in transistors 30 and 32. This ratio is initially established by the current sources (28 and 42) and the precise control of device geometry in the fabrication of the current sources. Device geometry is an IC property that can be controlled to a high degree of accuracy for a given IC. Once the ratio is established it will remain substantially constant since any variation in device properties of one of the transistors 30 or 32 in its fabrication or in its operation due to ambient temperature change will be compensated by equal variation in device properties of the other transistor. A similar compensation in device properties is effective for transistors 40 and 74 of the output network 41 (and for transistors 34 and 36 of the linear differential amplifier 37, which is active in AM mode).

For the first dynamic FM condition (unmodulated IF carrier present), a positive polarity signal present at the base of either transistor 24 or 26 will correspondingly increase the voltage at the commoned emitters above their static voltage level. Accordingly, for purposes of illustration, it may be assumed that the base of transistor 30 will respond to a positive going voltage for 3/4 cycle of the FM-IF and to a negative going voltage for 1/4 cycle. Since the zero crossing detector exhibits a high gain due to the dual, regenerative coupling connections between the transistor 30 and the transistor 32, during the 3/4 cycle transistor 30 rapidly increases its conduction to become fully saturated (one limiting condition), and transistor 32 rapidly decreases its conduction to become non-conductive (the other limiting condition). Conversely, during the 1/4 cycle transistor 30 rapidly becomes non-conductive and transistor 32 fully saturated. The 3:1 ratio (3/4 cycle to 1/4 cycle) corresponds to the 0 6 I:0.2 I current ratio, in the static FM condition, of transistors 32, 30, and gives rise to the same dc output current for both FM conditions. Integrative effects contributed by the output network 41, as well as the de-emphasis network 6, provide the same dc output current in the first dynamic FM condition, as in the static FM condition (no IF signal present). In response to an FM signal modulated with audio (the second dynamic condition) the duty cycle operation of the transistors 30 and 32 varies continuously from cycle to cycle of the FM-IF.

The output current of the zero crossing detector 33 which is the current in transistor 32, flows substantially solely through transistor 40 of network 41. For this consideration, the additional base current of transistor 76 is negligible. By virtue of the current multiplication provided by transistors 40 and 74, an amplified FM detected output current flows into the load resistance 82. The multiplication factor is made extremely precise by controlling the base-emitter junction geometry of transistor 74 in relation to that of transistor 40 and by proportioning their emitter resistors 78 and 80. In this example the junction area of transistor 74 is twice that of transistor 40 and the value of resistor 80 is one half of that resistor 78, to provide a current multiplication of two. Typical values are 600 ohms and 1.2 k. Transistor 76 serves to effectively buffer the current of transistor 74 from that of transistor 32 (or 36 in AM) by reducing that portion of the transistor 74 base current flowing to transistor 32 (or 36 in AM) by the current gain factor of transistor 76, and also to provide the enabling collector voltage for transistor 32 in FM-mode (or for transistor 36 in AM mode). The precisely controlled circuit configuration of the output amplifier network 41 assures that no significant change in output current shall occur due to IC process variations or ambient temperature changes. Thus, there is provided from the output of network 41 a more faithful, distortion reduced, temperature stable FM detected output signals and correspondingly accurate AFC signals.

The procedure for aligning, at the factory, the IF amplifier and FM-AM detector 1 for FM-operation is similar to, but more precise than the procedure given in DD. It is briefly summarized here. One begins with the radio receiver in the static condition, and measures dc voltages which exist at the pads of the IC chip, and at other accessible points external to the IC chip, in order to determine whether they fall within requirements. Of particular interest here is the dc voltage at the output terminal 84 (line X1), which for FM mode is typically +1.7 volts. It will be assumed for convenience in description, that the measured voltage is exactly +1.7 volts, and that the dc voltmeter remains connected to terminal 84 for the remainder of the procedure.

The *FM*-section of the AM-FM converter 3 contains an FM-mixer transistor (see DD, CC or AA), whose base in operational use as radio receiver, accepts FM-RF signal from the antenna 2 and also FM-local oscillator injection. FM-IF output (10.7 Mhz carrier) is developed, in operational use as radio receiver, at the collector of the FM-mixer transistor, by virtue of the fact that the latter collector is connected to a first FM-IF variable-inductance tuneable circuit, which is coupled to a second FM-IF variable-inductance tuneable circuit, which in turn is coupled to the on-the-IC-chip part of IF amplifier (see DD, CC or AA).

For factory alignment purposes, there is no FM-RF injection as yet; the radio receiver is deliberately set to an FM radio frequency which is outside of the 88 to 108 Mhz FN broadcast band. Instead, swept frequency modulated IF carrier (10.7 Mhz) is injected into the base of the FM-mixer transistor, from an FM Sweep Generator, which also provides a marker signal at 10.7 Mhz. A cathode ray oscilloscope (CRT) is connected through an intervening detector pad (see DD) to the output of the second FM-IF tuned circuit. The first and second FM-IF tuneable circuits are adjusted usually repeatedly, to obtain on the CRT a display reflecting maximum gain, and best symmetry about 10.7 Mhz which is indicated on the CRT by marker.

In the next step, the *FM* Sweep Generator remains connected to the base of the FM-mixer transistor, but the CRT is now connected through a resistor (rather than a detector probe) to terminal 84 (Figure 2).

The "third" FM-IF tuned circuit 11 (Figure 2) is tuneable by adjustment of the inductor 11A, and the "Quadrature" FM-IF tuned circuit 12 is tuneable by adjusting the FM transformer 15, and thereby adjusting inductors 15A and 15B. The tuned circuits 11 and 12 are adjusted, usually repeatedly, and subsequently the tuned circuit 12 is adjusted alone, to obtain the following criteria, as displayed on the CRT with the 10.7 Mhz marker as indicative of the FM-IF, in the CRT display: (1) Maximum gain consistent with linearity in the +75 khz range centered about 10.7 Mhz. (2) Symmetry of the displayed S-curve centered about the 10.7 Mhz marker, consistent with continued indication, by the voltmeter, of +1.7 volts dc, as under static conditions. As an additional verification of the alignment, in the FM sweep generator, the amplitude of the modulating signal may be reduced to zero, and the voltmeter should again indicate +1.7 volts dc; this is the first dynamic condition.

The FM-RF alignment, and the entire AM-alignment, are essentially as described in DC.

It has been mentioned in this Section "Operation-FM Mode," that the diode 52 has a negative temperature coefficient, whereas resistors 54 and 44 have a positive temperature coefficient. It is, of course, usually true that IC resistors in general have positive temperature coefficient, whereas IC diode junctions or transistor base-emitter junctions have negative temperature coefficient, meaning that with increase in temperature there is a decrease in the volt-drop across such junctions.

Operation—AM mode

During AM signal detection the mode select switch 46 is at the potential of $V_3$ (about +1.2 volts); this renders transistors 28, 42, 66, 68 and 70 non-conductive, and third current source transistor 60 conductive. Zero crossing detector 33 is inactive and linear differential amplifier 37 active. The inphase AM signal coupled to the base of transistor 24, having an input waveform shown by curve 100 in Graph E, and the 180° phase shifted signal coupled to the base of transistor 26, having an input waveform shown by curve 102 in Graph F, are full wave rectified and formed into a peak detected output voltage at the commoned emitters of transistors 24 and 26 through integration provided by the total inherent circuit capacitance at the base of transistor 34. The peak detected waveform is shown in Graph G as curve 104. The bases of transistors 24 and 26 are dc-wise coupled to $V_1$ (+3 volts) and the base of transistor 62, which has a base-emitter junction area twice that of each of transistors 24 and 26, is also coupled to $V_1$. Thus, for the condition of no AM-IF signal present, equal bias currents are supplied to transistors 34 and 36 to provide equal conduction therein, each transistor conducting one half of the current of third constant current source transistor 60. In response to an AM-IF signal applied to transistors 24 and 26, the voltage at the base of transistor 34 increases accordingly to increase conduction in this transistor and reduce conduction in transistor 36, in proportion to the amplitude of the AM-IF signal modulation. The output current of the differential amplifier 37, which is the current in transistor 36, flows substantially solely through transistor 40 of output network 41. Transistor 74 provides current multiplication of the detected AM signal in similar manner described with respect to the FM signal detection operation, so as to generate an amplified AM detected output current that flows into load resistance 82.

The current in constant current source transistor 60 is highly temperature stable due to the coupling of its base to the junction 59 of resistors 48 and 50 of the temperature stable network, as previously discussed. Furthermore, as a result of the generation of an output current by the symmetrical circuit arrangement of the differential amplifier transistors 34 and 35, any change in device properties in one of the transistors that may occur due to IC process variations will be compensated by a comparable change in properties of the other transistor so as to nevertheless generate an output current that accurately reflects the AM signal modulation. The dc AGC signals are similarly temperature-stabilized.

In addition to temperature stabilization, and compensation for variations due to the IC chip manufacturing process, the AM-detector described herein exhibits other significant improvements vis-a-vis that of BB or CC. Two such significant improvements are:

(1) The capability of the AM detector 1 of this invention, and more particularly the full-wave rectifier (transistor 24, 26), to accept from the IF amplifier's final stage 135, via the AM filter 20, AM IF signals of greater amplitude and without distorting the AM IF signals, than could be handled by the counterpart circuits of BB or CC. The base of each transistor 24, 26 can accept as much as 2 volts peak to peak AM IF carrier modulated by as much as 100%— meaning 4 volts peak to peak maximum— without distorting the incoming IF signal nor the outgoing audio signal, and with ample safety margin for the specified 2 volts peak to peak (4 volts peak to peak maximum). In contrast, the limiting values for the corresponding transistors of BB (its Q1, Q2) or CC (its Q18, Q19) were 1 volt peak to peak AM IF carrier or 2 volts peak to peak maximum (for 100% modulation), and with very little safety margin.

(2) Improved AGC characteristic, i.e. extended dynamic AGC range, vis-a-vis that of CC (or BB or even AA). The more limited dynamic AGC range of typically CC, discussed in this paragraph, and the more limited cabability of accepting at best 1 volt peak to peak AM IF carrier (2 volts peak to peak maximum), mentioned in the preceding paragraph, go hand in hand; they stem from one and the same limitation of the AM full-wave rectifier detector of typically CC (its Q18, Q19), namely that the bases and also the collectors of Q18, Q19 (of CC) were energized by +6 volts dc. The consequences of this will now be discussed; note that in contrast to CC the bases of transistor 24, 26 are energized by +3 volts, which is appreciably less than the +6 volt energization applied to their collectors.

The base-collector junction of an NPN transistor such as 24, 26 thereof, is under normal conditions a reverse biased diode. By normal condition is meant that the collector is at higher potential than the base. As a reverse biased diode, the base-collector junction presents a very high impedance to signal incoming to the base. If however, the base potential is permitted to approach and then even slightly exceed the collector potential—a phenomenon which in BB or CC might occur were the +2 volt maximum positive peak exceeded—the base-collector junction becomes a forward-biased diode which is virtually a short-circuit to the signal incoming to the base. In consequence the incoming IF signal is slipped or limited, which results not only in audio distortion, but also introduces a new rectified dc component which in effect causes the dc AGC voltage to limit. As so limited, the AGC dc voltage is propagated through the AM preamplifier (herein transistors 34, 36, 40, 74), the AFC-AGC amplifier (herein 9), to the primary and secondary buses (herein 131, 132), and then into the IF amplifier (herein 4) and the AM mixer stage and even the AM local oscillator stage (both contained in block 3 hereof). Therefore in CC, the AGC dynamic range extended to the point where the AM RF signal attained such a magnitude, as to cause the IF amplifier to deliver to the bases of the detector-rectifiers (its Q12, Q19) AM-IF signal which exceeded the 2 volt peak to peak maximum. The receiver of CC was designed, by constraints imposed on the AM mixer and the IF amplifier, to insure that the 2 volt peak to peak maximum was normally not exceeded.

It should be understood that the dynamic AGC characteristic of a given AM radio receiver has a definite lower limit—not too significant here—and an upper limit. At the lower end, i.e. low amplitude AM-IF signal is insufficient to develop adequate AGC dc signal. At the upper end of the amplitude of the received AM-RF signal might be abnormally high for the given receiver—as an extreme, the receiver might be positioned very close to the transmitting antenna—so as to overload the most vulnerable stage in the AGC dc loop, e.g. the AM mixer, the IF amplifier, the rectifier-detector, the AM preamplifier or even the AGC amplifier. If for example the IF amplifier is overloaded, not only is the audio output distorted, but the dc rectification which results from such overload causes breakdown of the AGC performance. In CC, owing to the +6 volt dc energization of the collectors, and also the bases of the rectifier-detector stage (its Q18, Q19), the breakdown occurred when the incoming AM IF signal exceeded the 2 volt peak to peak maximum; this condition normally did not come about, because of constraints on the AM mixer and IF amplifier, as mentioned above.

In the AM rectifier-detector stage of the present invention (transistors 24, 26) forward biasing of the base-collector junctions of these transistors will not occur, even with 4 volt peak to peak maximum applied to either base; this because the collectors receive +6 volts dc, and the bases +3 volt dc.

Another distinction of the FM-AM detector 1 vis-a-vis that of BB or CC, is that PNP transistor 74 and its associated circuit components, is utilized more efficiently than its counterpart in BB or CC; this, because transistor 74 is active in both FM mode and AM mode. Considering BB as an exemplary also for CC, in BB two corresponding PNP transistors were utilized, namely Q10, active in FM mode and inactive in AM mode, and Q5, inactive in FM mode and active in AM mode, with their associated circuit components partly shared in FM and AM mode.

The circuitry depicted in Figure 2 possesses a further important advantageous feature, which however was true also of the circuitry of BB or CC. For purposes of this paragraph, assume that we are considering AM broadcast stations for which the AM-RF signals received by the receiver are of normal signal strength, i.e., not weak nor unusually high, with approximately equal modulation percentage. As the radio receiver is successively tuned in to these AM stations, approximately the same audio signal strength will be developed at the output terminal 84 due to AGC action, so that the listener need not reset the audio volume control. Next, make the same assumption, but for FM broadcast stations. As the radio receiver is successively tuned in to these FM stations, again approximately the same audio signal strength will be developed at terminal 84, but for another reason, namely that this is inherent in the frequency modulation concept itself, so that again the listener need not reset the volume control. The important advantageous feature is that in switching reception from one such AM broadcast station to one such FM broadcast station or vice versa, again approximately the same audio signal strength will be developed at terminal 84, so that again the listener need not reset the volume control. The circuitry of Figure 2, inclusive of the AM—FM detector 1, was designed to accommodate this feature as well.

## Claims

1. An AM-FM detector circuit (1) of integrated circuit format for use in an AM-FM broadcast receiver, said circuit when it is in operational use, being selectively responsive to signals frequency modulated upon an FM-IF (intermediate frequency) carrier, or amplitude modulated upon an AM-IF carrier, comprising: (a) a differentially connected emitter follower pair of transistors (24, 26) of matching current conduction properties, the collectors of which, in operational use, are coupled to a dc voltage source ($V_2$), the emitters of which are joined, and the bases of which in FM operational use, receive said frequency modulated signals in a phase relationship which is continuously variable about a 90° phase displacement which exists at the FM-IF carrier frequency, and which in AM operational use receive said amplitude modulated signals in an inverse phase relationship, whereby produced at said emitters in FM operational use is a bipolar voltage train having zero-crossing widths which are proportionally related to the modulating signals, and whereby produced at said emitters in AM operational use is a detected voltage resulting from full wave rectification of the amplitude modulated carrier, (b) a zero crossing detector (33) active in FM operational use and responsive to said bipolar voltage train at said emitters to generate a current pulse train (96) of relatively constant amplitude and of pulse widths corresponding to said zero crossing widths, and characterized by (c) a linear differential amplifier (37) active in AM operational use and responsive to said detected voltage at said emitters (24, 26) for providing linear amplification of that voltage by generating a corresponding amplified current, and (d) a transistorized output amplifier (41) whose transistors are active in either FM operational use or AM operational use, said output amplifier (41), in FM operational use, being responsive to the current pulse train generated by said zero crossing detector (33) to integrate the current pulses and thereby to recover the original audio modulation and to provide a dc signal utilizable in the receiver for automatic frequency control (AFC), and being responsive in AM operational use to the current generated by said linear differential amplifier (37) to provide the recovered original audio modulation and a dc signal utilizable in the receiver for automatic gain control (AGC).

2. Apparatus according to Claim 1 characterized in that said zero crossing detector (33), linear differential amplifier (37) and output amplifier (41), each comprise a pair of transistors (30, 32; 34, 36; 40, 74) of matching current conduction properties connected in such a circuit configuration, that any change in properties of one transistor of the pair, due to fabrication process variation or ambient temperature variation, will be compensated by a corresponding change in properties of the other transistor of the pair, whereby said circuit, in operational use, exhibits minimal output signal variations in the recovered audio, and in the AFC or AGC signals.

3. Apparatus according to Claim 2, wherein connected to the emitters of the emitter follower transistor pair (24, 26) are: (a) a first current source (28) which is active in FM operational use, and as so active causes the emitter follower pair to produce the bipolar voltage train (96), and (b) the base of the input transistor (30) of the zero crossing detector transistor pair (30, 32), the emitters of the latter pair (30, 32) being joined and coupled to a second current source (42) which is active in FM operational use, and as so active causes activation of the zero crossing detector (33), the collector of the input transistor (30) of the zero crossing detector (33) being conductor-connected to the base of the output transistor (32) thereof, and being further connected via a diode (38)—which is poled to permit collector current flow into that input transistor (30)—to a conductor which in operational use is energized by the same dc supply voltage ($V_1$), as the bases of the emitter follower pair transistors (24, 26), characterized in that the collector circuit of the latter input transistor (30) is isolated from the collector of the latter output transistor (32), whereby when said apparatus is energized for FM operational use, in either the static condition of no FM-IF signal applied to the bases of the emitter-follower pair (24, 26) or the dynamic condition of FM-IF signal applied to them, said diode (38) passes solely the base current of said output transistor (32) and the entire collector current of said input transistor (30), said current sources (28, 42) and their associated circuitry (54, 44) being so constructed and the emitter follower transistors (24, 26) and the zero-crossing detector transistors (30, 32) being so constructed, that in said static FM condition substantially equal to each other are the emitter currents of the emitter follower pair (24, 26) and of the output transistor (32) of the zero-crossing detector (33), and the emitter current of its input transistor (30) is in a predetermined ratio to that of its output transistor (32).

4. Apparatus according to Claim 3, characterized in that said predetermined ratio is substantially 3:1.

5. Apparatus according to Claim 3 or 4 wherein the collectors of the emitter follower transistor pair (24, 26) are joined together, and to a conductor, characterized in that the latter conductor is energized, in either FM or AM operational use, by a second dc voltage source ($V_2$) which provides substantially greater dc voltage than the first voltage source ($V_1$).

6. Apparatus according to Claim 5, characterized in that the base of the linear differential amplifier's input transistor (34) is coupled to the commoned emitters of the emitter follower transistor pair (24, 26), its emitter and also the emitter of its matched output transistor (36) are coupled via respective, equivalue resistances (56, 58) to a third current source (60) which is activatable in AM operational use to activate the linear differential amplifier (37), that the collector of the linear differential amplifier's output transistor (36) is conductor-connected to the collector of the zero-crossing detector's output transistor (32) and to the input of the transistorized output amplifier (41), and that the base of the linear differential amplifier's output transistor (36) is connected via the emitter-collector path of an additional transistor (62) to the collectors of the differential emitter follower transistor pair (24, 26), the base of the latter additional transistor (62) being energized, in operational use, by the first voltage source ($V_1$).

7. Apparatus according to Claim 6, characterized in that the transistors of said emitter follower pair (24, 26), of said zero-crossing detector (30, 32), of said linear differential amplifier (34, 36, 62), and of said current sources (28, 42, 60), are NPN transistors.

8. Apparatus according to Claim 7, characterized in that said transistorized output amplifier (41) is composed of PNP transistors (40, 74, 76) and comprises, in order from its own input to its own output: a first (40) and a second (76) PNP transistor, the collector of the former (40) being conductor-connected to the base of the latter (76) and to the collector of zero crossing detector's output transistor (32), the base of the former (40) being conductor-connected to the emitter of the latter (76) and also to the base of a third PNP transistor (74) which is the final output stage of the output amplifier (41) and which at its collector, in operational use, provides the aforesaid amplified recovered audio signals and either the AM-AGC dc signal or the FM-AFC dc signal, the collector of the second PNP transistor (76) being coupled to an earth-point, the collector of the third PNP transistor (74) being coupled via a resistance (82) to that earth-point, and the emitters of the first (40) and of the third (74) PNP transistors each being coupled via a respective resistance (78, 80) to the joined collectors of the emitter follower transistor pair (24, 26).

9. Apparatus according to Claim 8, characterized in that the third PNP transistor (74) has a device geometry which is in a predetermined ratio to that of the first PNP transistor (40) so as to confer on the third PNP transistor (74) current multiplication capability by a predetermined ratio.

10. Apparatus according to Claim 9, characterized in that the emitter load resistances (78; 80) of the first and third PNP transistors (40, 74) respectively, have values which, considered in the order just stated, are in the latter predetermined ratio.

11. Apparatus according to Claim 9 or 10, characterized in that the latter predetermined ratio is substantially 2:1.

12. Apparatus according to Claim 7, characterized by a temperature compensating voltage-divider arrangement (48, 50, 52) which comprises in series order from a conductor, which in operational use is energized by the first-mentioned dc voltage source ($V_1$) to an earth-

point: a first temperature compensating network resistance (48), a second temperature compensating network resistance (50), and a temperature-compensating diode (52) poled to conduct current to the earth-point, the junction point (59) of the first and second temperature-compensating resistances being connected to the base of each of the current-source transistors (28, 42, 60).

13. Apparatus according to Claim 12 wherein each current source transistor (28, 42, 60) has its collector connected to the emitter-circuit of its respective transistor pair (24, 26; 30, 32; 34, 36), the emitter of the first, and of the second current source transistor (28, 42) being connected via a respective resistance (54, 44) to a mode-switching control bus (133) which in operational use is switchable to receive either earth potential in FM mode and thereby activate, i.e. render conductive, the first and second current sources, or to receive dc bias potential from a third source ($V_3$) in AM mode to deactivate, i.e. render non-conductive, the same, characterized in that the third current source's transistor's emitter is connected via a resistance (64) to an earth-point, and in that an AM-FM transistor switch network (65) is provided, which comprises: (a) a PNP transistor (68) whose emitter is connected to the high-potential end of the first temperature compensating resistance (48), and whose collector is connected to the emitter of the third current source transistor (60), (b) and NPN transistor (70) whose emitter is connected via a resistance (72) to the mode switching control bus (133), whose base is connected to the junction point (59) of the first and second temperature compensation resistances (48, 50), and whose collector is connected to the base of the last-mentioned PNP transistor (68), and (c) a semiconductor diode device (66) connected across the emitter and the base of the last-mentioned PNP transistor (68) and having therewith matched diode junction characteristics, the semiconductor diode device being poled to permit current conduction into the collector of the last-mentioned NPN transistor (70), whereby in operational use the third current source transistor is activated in AM-mode and deactivated in FM-mode.

14. Apparatus according to Claim 13, characterized in that the semiconductor diode device (66) is a diode-connected PNP transistor.

15. Apparatus according to Claim 12 or 13, characterized in that the ratio of the emitter circuit resistances of the first and the second current source transistors is substantially 6:4 in that order.

16. Apparatus according to Claim 5, further comprising an IF amplifier (4) which is active in either FM operational used or AM operational use and which includes a final stage (135) comprised of an input transistor (Q9) and an output transistor (Q10) which are dc-wise organized as a second differentially connected emitter follower pair, the collector of the latter output transistor being conductor connected to the base of one (24) of the first differentially connected emitter follower pair transistors (24, 26), characterized in that the latter input transistor's (Q9) collector is connected to a conductor which in either FM or AM operational use is energized by the first voltage source ($V_1$).

17. Apparatus as claimed in Claim 16, characterized in that the collectors of the linear differential amplifier's input and output transistors (34, 36) are conductor connected to the collectors of the emitter follower transistor pair (24, 26).

**Patentansprüche**

1. AM-FM-Abtastschaltung (1) im IC-Format zur Verwendung in einem AM-FM-Rundfunkempfänger, welche Abtastschaltung im Betrieb selektiv auf Signale anspricht, die auf einem FM-ZF (Zwischenfrequenz)-Träger frequenzmoduliert oder auf einem AM-ZF-Träger amplitudenmoduliert sind, mit folgenden Merkmalen: (a) ein differential-verbundenes Emitter-Folgerpaar aus Transistoren (24, 26) mit angepaßten Stromleitungseigenschaften, deren Kollektoren im Betrieb mit einer Gleichspannungsquelle ($V_2$) verbunden sind, deren Emitter miteinander verbunden sind und deren Basen im FM-Betrieb die frequenzmodulierten Signale in einer Phasenlage empfangen, die über eine 90°-Phasenverschiebung, die bei der FM-ZF-Trägerfrequenz existiert, kontinuierlich variabel ist und die im AM-Betrieb die amplitudenmodulierten Signale in einer umgekehrten Phasenlage empfangen, wodurch an den Emittern im FM-Betrieb eine bipolare Spannungskette mit Nulldurchgangsbreiten erzeugbar ist, die proportional zu den modulierenden Signalen ist, und wodurch an den Emittern im AM-Betrieb eine abgetastete Spannung erzeugbar ist, die aus der Vollweggleichrichtung des amplitudenmodulierten Trägers resultiert, (b) eine Nulldurchgangsdetektor (33) ist im FM-Betrieb aktiv und spricht auf die bipolare Spannungskette an den Emittern an zu Erzeugung einer Stromimpulskette (96) relativ konstanter Amplitude und Pulsbreiten entsprechend end Nulldurchgangsbreiten, gekennzeichnet durch (c) einen linearen Differentialverstärker (37), der im AM-Betrieb aktiv ist und auf die abgetastete Spannung an den Emittern (24, 26) anspricht zur linearen Verstärkung der Spannung, indem ein entsprechender verstärkter Strom erzeugt wird, und (d) einen transistorisierten Ausgangsverstärker (41), dessen Transistoren entweder im FM-Betrieb oder AM-Betrieb aktiv sind, wobei der Ausgangsverstärker (41) im FM-Betrieb auf die Stromimpulskette, die durch den Nulldurchgangsdetektor (33) erzeugt ist, anspricht, um die Stromimpulse zu integrieren und dadurch die ursprüngliche Audiomodulation zurückzugewinnen und ein Gleichstromsignal zu liefersn, das in dem Empfänger für die automatische Frequenzsteuerung (AFC) verwendbar ist, und wobei der Ausgangsverstärker (41) im AM-Betrieb auf den Strom anspricht, der durch den linearen Differentialverstärker (37 erzeugt ist, zur Lieferung der zurückgewonnenen, ursprünglichen Audiomodulation und eines Gleichstromsignals, das im Empfänger für die automatische Verstärkungssteuerung (AGC) verwendbar ist.

2. Abtastschaltung nach Anspruch 1, dadurch gekennzeichnet, daß der Nulldurchgangsdetektor (33), der lineare Differentialverstärker (37) und der Ausgangsverstärker (41) jeweils ein Paar Transistoren (30, 32; 34, 36; 40, 74) mit angepaßten Stromleitungseigenschaften aufweisen und derart geschaltet sind, daß jede Änderung in den Eigenschaften eines Transistors des Paars aufgrund einer Fertigungsprozeßänderung oder Umgebungstemperaturänderung durch .eine entsprechende Änderung in den Eigenschaften des anderen Transistors der Paars kompensiert ist, wodurch die Schaltung im Betrieb minimale Ausgangssignaländerungen in der zurückgewonnenen Audiomodulation und in den AFC- oder AGC-Signalen aufweist.

3. Abtastschaltung nach Anspruch 2, wobei mit den Emittern des Emitter-Folger-Transistorpaares (24, 26) verbunden sind: (a) eine erste Stromquelle (28), die im FM-Betrieb aktiv ist und im aktiven Betrieb bewirkt, daß das Emitter-Folgerpaar die bipolare Spannungskette (96) erzeugt, und (b) die Basis des Eingangstransistors (30) des Nulldurchgangsdetektor-Transistorpaares (30, 32), wobei die Emitter des letztgenannten Paares (30, 32) mit einer zweiten Stromquelle (42) verbunden und gekoppelt ist, die im FM-Betrieb aktiv ist und im aktiven Zustand die Aktivierung des Nulldurchgangsdetektors (33) bewirkt, wobei der Kollektor des Eingangstransistors (30) des Nulldurchgangsdetektors (33) durch einen Leiter mit der Basis dessen Àusgangstransistors (32) verbunden ist und der weiterhin über eine Diode (38)—die so gepolt ist, daß eine Kollektorstromfluß in den Eingangstransistor (30) gestattet ist—mit einem Leiter verbunden ist, der im Betrieb durch die gleiche Versorgungsgleichspannung (V$_1$) gespeist ist wie die Basen der paarigen Emitter-Folger-Transistoren (24, 26), dadurch gekennzeichnet, daß der Kollektorkreis von dem letztgenannten Eingangstransistor (30) von dem ˙Kollektor des letztgenannten Ausgangstransistors (32) getrennt bzw. isoliert ist, so daß, well die Schaltung für einen FM-Betrieb erregt ist, entweder im statischen Zustand, wenn kein FM-ZF-Signal und die Basen des Emitter-Folger-Paares (24, 26) angelegt ist, oder im dynamischen Zustand, wenn das FM-ZF-Signal an sie angelegt ist, die Diode (38) allein den Basisstrom des Ausgangstransistors (32) und den gesamten Kollektorstrom des Eingangstransistors (30) durchläßt, wobei die Stromquellen (28, 42) und ihre zugehörigen Schaltungen (54; 44) so aufgebaut und die Emitter-Folger-Transistoren (24, 26) und die Nulldurchgangsdetektor-Transistoren (30, 32) so aufgebaut sind, daß im statischen FM-Zustand die Emitterströme des Emitter-Folger-Paares (24, 26) und des Ausgangstransistors (32) des Nulldurchgangsdetektors (33) im wesentlichen zueinander gleich sind und der Emitterstrom seines Eingangstransistors (30) in einem vorbestimmten Verhältnis zu dem seines Ausgangstranssistors (32) ist.

4. Abtastschaltung nach Anspruch 3, dadurch gekennzeichnet, daß das vorbestimmte Verhältnis im wesentlichen 3:1 ist.

5. Abtastaschaltung nach Anspruch 3 oder 4, wobei die Kollektoren des Emitter-Folger-Transistorpaares (24, 26) miteinander und mit einem Leiter verbunden sind, dadurch gekennzeichnet, daß der Leiter eintweder im FM- oder AM-Betrieb durch eine zweite Gleichspannungsquelle (V$_2$) gespeist ist, die eine wesentliche größere Gleichspannung als die erste Gleichspannungsquelle (V$_1$) liefert.

6. Abtastshclatung nach Anspruch 5, dadurch gekennzeichnet, daß die Basis des Eingangstransistors (34) des linearen Differentialverstärkers mit den gemeinsamen Emittern des Emitter-Folger-Transistorpaares (24, 26) verbunden ist, dessen Emitter und weiterhin der Emitter seines angepaßten Ausgangstransistors (36) über entsprechende, gleiche Werte aufweisende Widerstände (56, 58) mit einer dritten Stromquelle (60) verbunden ist, die im AM-Betrieb aktivierbar ist zum Aktivieren des linearen Differentialverstärkers (37), daß der Kollektor des Ausgangstransistors (36) des linearen Differentialverstärkers durch einen Leiter mit dem Kollektor des Ausgangstransistors (32) des Nulldurchgangsdetektors und mit dem Eingang des transistorisierten Ausgangsverstärkers (41) verbunden ist, und daß die Basis des Ausgangstransistors (36) des linearen Differentialverstärkers über die Emitter-Kollektor-Strecke eines Zusätzlichen Transistors (62) mit den Kollektoren des Differential-Emitter-Folger-Transistorpaares (24, 26) verbunden ist, wobei die Basis des zusätzlichen Transistors (62) im Betrieb durch die erste Spannungsquelle (V$_1$) gespeist ist.

7. Abtastschaltung nach Anspruch 6, dadurch gekennzeichnet, daß die Transistoren des Emitter-Folger-Paares (24, 26), des Nulldurchgangsketektors (30, 32), des linearen Differentialverstärkers (34, 36, 62) und der Stromquellen (28, 42, 60) NPN-Transistoren sind.

8. Abtastschaltung nach Anspruch 7, dadurch gekennzeichnet, daß der transistorisierte Ausgangsverstärker (41) aus PNP-Transistoren (40, 74, 76) aufgebaut ist und in der Reihenfolge von seinem Eingang zu seinem Ausgang aufweist: einen ersten (40) und einen zweiten (76) PNP-Transistor, wobei der Kollektor des ersten (40) durch einen Leiter mit der basis des zweiten (76) und mit dem Kollektor des Ausgangstransistors (32) des Nulldurchgangsdetektors verbunden ist und die Basis des ersten (40) durch einen Leiter mit dem Emitter des zweiten (76) und auch mit der basis eines dritten PNP-Transitors (74) verbunden ist, der die letzte Ausgangsstufe des Ausgangsverstärkers (41) ist und der an seinem Kollektor im Betrieb die verstärkten, zurückgewonnenen Audiosignale und entweder das AM-AGC-Gleichstromsignal oder das FM-AFC-Gleichstromsignal liefert, und wobei der Kollektor des zweiten PNP-Transistors (76) mit einem Erdpunkt verbunden ist, der Kollektor des dritten PNP-Transistors (74) über einen Widerstand (82) mit dem Erdpunkt verbunden ist und die Emitter des ersten (40) und des dritten (74) PNP-Transistors jeweils über einen entsprechenden Widerstand (78, 80) mit den verbundenen Kollektoren des Emitter-Folger-Transistorpaares (24, 26) verbunden sind.

9. Abtastschaltung nach Anspruch 8, dadurch gekennzeichnet, daß der dritte PNP-Transistor (74) eine Geometrie aufweist, die in einem vorbestimmten Verhältnis zu derjenigen des ersten PNP-Transistors (40) steht, um so zu dem Strommultiplikationsvermögen des dritten PNP-Transistors (74) in einem vorbestimmten Verhältnis zu stehen.

10. Abtastschaltung nach Anspruch 9, dadurch gekennzeichnet, daß die Emitter-Lastwiderstände (78; 80) der ersten bzw. dritten PNP-Transistoren (40, 74) Werte haben, die in der angegebenen Reihenfolge in dem genannten vorbestimmten Verhältnis stehen.

11. Abtastschaltung nach Anspruch 9 oder 10, dadurch gekennzeichnet, daß das vorbestimmte Verhältnis im wesentlichen 2:1 ist.

12. Abtastschaltung nach Anspruch 7, gekennzeichnet durch eine temperatur-kompensierende Spannungsteilerschaltung (48, 50, 52), die in Reihenschaltung von einem Leiter, der im Betrieb durch die erste Gleichspannungsquelle (V₁) gespeist ist, zum Erdpunkt aufweist: einen ersten temperatur-kompensierenden Schaltungswiderstand (48), einen zweiten temperatur-kompensierenden Schaltungswiderstand (50) und eine temperatur-kompensierende Diode (52), die zur Stromleitung zum Erdpunkt gepolt ist, wobei der Knotenpunkt (59) der ersten und zweiten temperatur-kompensierenden Widerstände mit der Basis von jedem der Stromquellen-Transistoren (28, 42, 60) verbunden ist.

13. Abtastschaltung nach Anspruch 12, wobei von jedem Stromquellen-Transistor (28, 42, 60) sein Kollektor mit dem Emitterkreis seines entsprechenden Transistorpaares (24, 26; 30, 32; 34, 36) verbunden ist, der Emitter des ersten und des zweiten Stromquellen-Transistors (28, 42) über einen entsprechenden Widerstand (54, 44) mit einem Betriebsart-Umschalt-Steuerbus (133) verbunden ist, der im Betrieb umschaltbar ist, um entweder Erdpotential im FM-Betrieb zu empfangen und dadurch die ersten und zweiten Stromquellen zu aktivieren, d.h. leitend zu machen, oder eine Gleichvorspannung von einer dritten Quelle (V₃) im AM-Betrieb zu empfangen, um die ersten und zweiten Stromquellen zu deaktivieren, d.h. nicht-leitend zu machen, dadurch gekennzeichnet, daß der Transistoremitter der dritten Stromquelle über einen Widerstand (64) mit einem Erdpunkt verbunden ist, und daß eine AM-FM-Transistor-Umschaltschaltung (65) vorgesehen ist, die umfaßt: (a) einen PNP-Transistor (68), dessen Emitter mit dem Hochspannungsende des ersten temperatur-kompensierenden Widerstandes (48) verbunden ist und dessen Kollektor mit dem Emitter des Transistors (60 der dritten Stromquelle verbunden ist, (b) einen NPN-Transistor (70), dessen Emitter über einen Widerstand (72) mit dem Betriebsart-Umschalt-Steuerbus (133) verbunden ist, dessen Basis mit dem Knotenpunkt (59) der ersten und zweiten temperatur-kompensierenden Widerstände (48, 50) verbunden und dessen Kollektor mit der Basis des PNP-Transistors (68) verbunden ist, und (c) eine Halbleiter-Diodenvorrichtung (66), die über den Emitter und die basis des PNP-Transistors (68) geschaltet ist und dazu angepaßte Dioden-Übergang-scharakteristiken aufweist, wobei die Halb-leiter-Diodenvorrichtung so gepolt ist, daß sie eine Stromleitung in den Kollektor des NPN-Transistors (70) gestattet, wodurch im Betrieb der dritte Stromquellen-Transistor im AM-Betrieb aktiviert und im FM-Betrieb deaktiviert ist.

14. Abtastschaltung nach Anspruch 13, dadurch gekennzeichnet, daß die Halbleiter-Diodenvorrichtung (66) ein als Diode geschalteter PNP-Transistor ist.

15. Abtastschaltung nach Anspruch 12 oder 13, dadurch gekennzeichnet, daß das Verhältnis der Emitterkreiswiderstände der ersten und zweiten Stromquellen-Transistoren im wesentlichen 6:4 beträgt.

16. Abtastschaltung nach Anspruch 5, wobei ferner ein ZF-Verstärker (4) vorgesehen ist, der entweder im FM-Betrieb oder im AM-Betrieb aktiv ist und der eine Endstufe (135) enthält, die einen Eingangstransistor (Q9) und einen Aus-gangstransistor (Q10) aufweist, die gleich-strommäßig als ein zweites differentialgeschal-tetes Emitter-Folger-Paar aufgebaut sind, wobei der Kollektor des letzten Ausgangstransistors durch einen Leiter mit der Basis des einen (24) der ersten differential-geschalteten Emitter-Folger-Paartransistoren (24, 26) verbunden ist, dadurch gekennzeichnet, daß der Kollektor des Eingangstransistors (Q9) mit einem Leiter verbunden ist, der entweder im FM- oder AM-Betrieb durch die erste Spannungsquelle (V₁) gespeist ist.

17. Abtastschaltung nach Anspruch 16, dadurch gekennzeichnet, daß die Kollektoren der Eingangs- und Ausgangstransistoren (34, 36) des linearen Differentialverstärkers durch einen Leiter mit den Kolllektoren des Emitter-Folger-Transistorpaares (24, 26) verbunden sind.

## Revendications

1. Circuit détecteur AM-FM (1) du format du circuit intégré pour l'utilisation dans un récepteur radiophonique AM-FM, ce circuit lorsqu'il est en service, étant sélectivement sensible à des signaux modulés en fréquence sur une porteuse FM-IF (fréquence intermédiaire), ou modulés en amplitude sur une porteuse AM-IF, comprenant: a) une paire de transistors (24, 26) à émetteurs-suiveurs branchés différentiellement ayant des propriétés de conduction du courant harmonisées, dont les collecteurs, en service, sont couplés à une source de courant continu $(V_2)$, dont les émetteurs sont réunis, et dont les bases en service en fonctionnement FM, reçoivent les signaux modulés en fréquence suivant une relation de phase qui varie continuement autour d'un déphasage de 90° qui existe à la fréquence de la porteuse FM-IF, et qui en service en fonctionnement AM reçoivent les signaux modulés en amplitude suivant une relation de phase inverse, grâce à quoi est produit à ces émetteurs en service en fonctionnement FM un train de tension bipolaire ayant des largeurs de passage par zéro qui sont proportionnellement liées aux signaux de modulation, et grâce à quoi est produite à ces émetteurs en service en fonctionnement AM une tension détectée résultant d'un redressement double alternance de la porteuse modulée en amplitude, (b) un détecteur de passage par zéro (33) actif en service en fonctionnement FM et sensible au train de tension bipolaire aux émetteurs pour engendrer un train d'impulsions de courant (96) d'amplitude relativement constante et de largeurs d'impulsions correspondant aux largeurs de passage par zéro, et caractérisé par (c) un amplificateur différentiel linéaire (37) actif en service en fonctionnement AM et sensible à la tension détectée aux émetteurs (24, 26) pour fournir l'amplification linéaire de cette tension en engendrant un courant amplifié correspondant, et (d) un amplificateur de sortie transistorisé (41) dont les transistors sont actifs soit en service en fonctionnement FM soit en service en fonctionnement AM, cet amplificateur de sortie (41), en service en fonctionnement FM, étant sensible au train d'impulsions de courant engendré par le détecteur de passage par zéro (33) pour intégrer les impulsions de courant et ainsi récupérer la modulation audio originale et fournir un signal de courant continu utilisable dans le récepteur pour la commande automatique en fréquence (AFC), et étant sensible en service en fonctionnement AM au courant engendré par l'amplificateur différentiel linéaire (37) pour fournir la modulation audio originale et un signal de courant continu utilisable dans le récepteur pour une commande automatique de gain (AGC).

2. Appareil selon la revendication 1, caractérisé en ce que le détecteur de passage par zéro (33), l'amplificateur différentiel linéaire (37) et l'amplificateur de sortie (41), comprennent chacun une paire de transistors (30, 32; 34, 36; 40, 74) de propriétés de conduction de courant harmonisées suivant une configuration de circuit telle, que tout changement des propriétés d'un transistor d'une paire, due à des variations du procédé de fabrication ou de la température ambiante, sera compensé par un changement correspondant des propriétés de l'autre transistor de la paire, grâce à quoi le circuit, en service, présente des variations minimales de signal de sortie dans le signaux audio récupérés, et les signaux AFC ou AGC.

3. Appareil selon la revendication 2 caractérisé en ce que sont reliées aux émetteurs de la paire de transistors à émetteurs-suiveurs (24, 26): (a) une première source de courant (28) qui est active en service en fonctionnement FM, et de ce fait oblige la paire de transistors à émetteurs-suiveurs à produire un train de tension bipolaire (96), et (b) la base du transistor d'entrée (30) de la paire de transistors (30, 32) du détecteur de passage par zéro, les émetteurs de cette dernière paire (30, 32) étant réunis et couplés à une seconde source de courant (42) qui est active en service en fonctionnement FM, et de ce fait provoque l'activation du détecteur de passage par zéro (33), le collecteur du transistor d'entrée (30) du détecteur de passage par zéro (33) étant relié par conducteur à la base du transistor de sortie (32) du détecteur et en outre relié par une diode (38)—polarisée pour permittre le passage du courant de collecteur dans le transistor d'entrée (30)—à un conducteur qui, en service, est alimenté par la même tension de source de courant continu $(V_1)$ que les bases de la paire de transistors (24, 26) à émetteurs-suiveurs, caractérisé en ce que le circuit de collecteur de ce dernier transistor d'entrée (30) est isolé du collecteur du dernier transistor de sortie (32), grâce à quoi lorsque l'appareil est alimenté pour un service en fonctionnement FM, soit à l'état statique où aucun signal FM-IF n'est appliqué aux bases de la paire de transistors (24, 26) à émetteurs-suiveurs soit à l'état dynamique où le signal FM-IF leur est appliqué, cette diode (38) laisse passer seulement le courant de base du transistor de sortie (32) et la totalité du courant de collecteur du transistor d'entrée (30), ces sources de courant (28, 42) et leur circuiterie associée (54; 44) étant construits de telle façon et les transitors à émetteurs-suiveurs (24, 26) et les transitors (30, 32) du détecteur de passage par zéro étant construits de telle façon, qu'à l'état FM statique, les courants d'émetteur de la paire de transistors à émetteurs-suiveurs (24, 26) et du transistor de sortie (32) du détecteur de passage par zéro (33) sont substantiellement égaux, les uns aux autres, et le courant d'émetteur de son transistor d'entrée (30) se trouve dans un rapport prédéterminé avec celui de son transistor de sortie (32).

4. Appareil selon la revendication 3, caractérisé en ce que le rapport prédéterminé est substantiellement 3:1.

5. Appareil selon la revendication 3 ou 4 dans lequel les collecteurs de la paire de transistors (24, 26) à émetteurs-suiveurs sont réunis ensemble, et à un conducteur, caractérisé en ce que le dernier conducteur est alimenté, en service soit en fonctionnement FM soit en fonctionnement AM, par une seconde source de tension continue ($V_2$) qui fournit une tension continue substantiellement plus grande que la première source de tension ($V_1$).

6. Appareil selon la revendication 5 caractérisé en ce que la base du transistor d'entrée (34) de l'amplificateur linéaire est couplée aux émetteurs rendus communs de la paire de transistors (24, 26) à émetteurs-suiveurs, son émetteur et aussi l'émetteur de son transistor de sortie harmonisé (36) sont couplés par des résistances de valeur équivalente, respectives, (56, 58) à une troisième source de courant (60) qui peut être rendu actif en service en fonctionnement AM pour activer l'amplificateur différenciel linéaire (37), en ce que le collecteur du transistor de sortie (36) de l'amplificateur différentiel linéaire est relié par conducteur du collecteur du transistor de sortie (32) du détecteur de passage par zéro et à l'entrée de l'amplificateur de sortie transistorisé (41), et en ce que la base du transistor de sortie (36) de l'amplificateur différentiel linéaire est reliée par le trajet émetteur-collecteur d'un transistor supplémentaire (62) aux collecteurs de la paire de transistors différentiels (24, 26) à émetteurs-suiveurs, la base de ce dernier transistor supplémentaire (62) étant alimentée, en service, par la première source de tension ($V_1$).

7. Appareil selon la revendication 6 caractérisé en ce que les transistors de la paire de transistors (24, 26) à èmetteurs-suiveurs, du détecteur de passage par zéro (30, 32), de l'amplificateur différentiel linéaire (34, 36, 62), et des sources de courant (28, 42, 60), sont des transistors NPN.

8. Appareil selon la revendication 7 caractérisé en ce que l'amplificateur de sortie transistorisé (41) est composé de transistors PNP (40, 74, 76) et comprend, dans l'ordre de puis sa propre entrée jus-qu'à sa propre sortie: un premier (40) et un second (76) transistor PNP, le collecteur du premier (40) étant relié par conducteur à la base du dernier (76) et au collecteur du transistor de sortie (32) du détecteur de passage par zéro, la base du premier (40) étant reliée par conducteur à l'émetteur du dernier (76) et aussi à la base d'un troisième transistor PNP (74) qui est l'étage de sortie final de l'amplificateur de sortie (41) et qui, à son collecteur, en service, fournit les signaux audio récupérés amplifiés susmentionnés et soit le signal de courant continu AM-AGC soit le signal de courant continu FM-AFC, le collecteur du second transistor PNP (76) étant couplé à un point de terre, le collecteur du troisimème transistor PNP (74) étant couplé par une résistance (82) à ce point de terre, et les émetteurs du premire (40) et du troisième (74) transistors PNP étant couplés par une résistance respective (78, 80) aux collecteurs rénuis de la paire de transistors (24, 26) à émetteurs-suiveurs.

9. Appareil selon la revendication 8, caractérisé en ce que le troisième transistor PNP (74) a une géométrie qui est dans un rapport prédéterminé par rapport à celle du premier transistor PNP (40) afin de conférer à ce troisième transistor PNP (74) une aptitude à la multiplication de courant par un rapport prédéterminé.

10. Appareil selon la revendication 9, caractérisé en ce que les résistances de charge d'émetteur (78; 80) du premier et du troisième transistors PNP (40, 74) respectivement, ont des valeurs qui, considérées dans l'ordre juste indiqué, sont dans le rapport prédéterminé.

11. Appareil selon la revendication 9 ou 10, caractérisé en ce que le rapport prédéterminé est substantiellement 2:1.

12. Appareil selon la revendication 7, caractérisé par un agencement diviseur de tension pour la compensation de température (48, 50, 52) qui comprend end série, dans l'ordre, depuis un conducteur qui en service est alimenté par la source de tension continue mentionnée en premier ($V_1$) jusqu'à un point de terre: une première résistance de compensation de la température (48), une seconde résistance de compensation de la température (50), et une diode de compensation de la température (52) polarisée pour conduire du courant vers le point de terre, le point de jonction (59) de la première et de la seconde résistances de compensation de la température étant relié à la base de chacun des transistors des sources de courant (28, 42, 60).

13. Appareil selon la revendication 12, dans lequel chaque transistor des sources de courant (28, 42, 60) a son collecteur relié au circuit d'émetteur de la paire de transistors respective (24, 26; 30, 32; 34, 36), l'émetteur du premier transistor de la première, et de la seconde sources de courant (28, 42) étant relié par une résistance respective (54, 44) à un bus de commande de commutation de mode (133) qui, en service, est commutable pour recevoir soit le potentiel de terre au mode FM et ainsi activer, c'est-à-dire rendre conducteur, la première et la seconde sources de courant, ou pour recevoir un potentiel continu de polarisation d'une troisième source ($V_3$) en mode AM pour désactiver, c'est-à-dire rendre non conducteur, les mêmes, caractérisé en ce que l'émetteur du transistor de la troisième source de courant est relié par la résistance (64) à un point de terre, et en ce qu'est prévu un réseau de commutation AM-FM à transistors (65), qui comprend: (a) un transistor PNP (68) dont l'émetteur est relié à l'extrêmité de potentiel élevé de la première résistance de compensation de température (48), et dont le collecteur est relié à l'émetteur du transistor de la troisième source de courant (60), (b) un transistor NPN (70) dont l'émetteur est relié par une résistance (72) au bus de commande de commutation de mode (133), dont la base est reliée au point de jonction (59) de la première et de la seconde résistances de compensation de température (48, 50), et dont le collecteur est relié à la base du transistor PNP nommé en dernier (68), et (c) un dispositif semi-conducteur à diode (66) relié entre l'émetteur et la base du transistor PNP nommé en dernier (68) et ayant avec celui-ci des caractéristiques de jonction de diode harmonisées, ce dispositif semi-conducteur à diode étant polarisé pour permettre la conduction de courant dans le collecteur du transistor NPN mentionné en dernier (70), grâce à quoi en service le transistor de la troisième source de courant est activé en mode AM et désactivé en mode FM.

14. Appareil selon la revendication 13, caractérisé en ce que le dispositif semi-conducteur à diode (66) est un transistor PNP relié à une diode.

15. Appareil selon la revendication 12 ou 13 caractérisé en ce que le rapport des résistances du circuit d'émetteur des transistors de la première et de la seconde sources de courant est de 6:4 dans cet ordre.

16. Appareil selon la revendication 5, comprenant en outre un amplificateur IF (4) qui est actif soit en service dans le mode FM soit en service dans le mode AM et qui comprend un étage final (153) constitué d'un transistor d'entrée (Q9) et d'un transistor de sortie (Q10) qui sont organisés comme en courant continu comme une seconde paire à émetteurs-suiveurs branchée différentiellement, le collecteur de ce dernier transistor de sortie étant relié par conducteur à la base d'un (24) des transistors de la première paire à émetteurs-suiveurs branchée différentiellement (24, 26) caractérisé en ce que le collecteur du dernier transistor d'entrée (Q9) est relié à un conducteur qui, en service soit en fonctionnement FM soit en fonctionnement AM, est alimenté par la première source de tension ($V_1$).

17. Appareil selon la revendication 16 caractérisé en ce que les collecteurs des transistors d'entrée et de sortie (34, 36) de l'amplificateur différentiel linéaire sont reliés par conducteur aux collecteurs de la paire de transistors à émetteurs-suiveurs (24, 26).

Fig.1

Fig.3

0 020 744

Fig.2